# EUROPEAN PATENT APPLICATION

(11) **EP 0 652 446 A2**
(43) Date of publication of application: **10.05.1995**
(21) Application number: 94420296.9
(22) Date of filing: 28.10.1994
(51) Int. Cl.: G01R 33/12

(54) **Apparatus and method for a magnetic image detector**

(30) Priority: 09.11.1993 US 149575
(71) Applicant: EASTMAN KODAK COMPANY, Rochester, New York 14650-2201 (US)
(72) Inventor: Jeffers, Frederick J., c/o Eastman Kodak Company, Rochester, New York 14650-2201 (US)
(74) Representative: Jones, Alan John

(57) **Abstract**

In order to measure the permeability of a magnetic material, a permanent magnet (22) is positioned at a distance from the surface (21) of a magnetic material (24). A magnetic field sensor (25) is placed proximate the magnetic material (24) on the magnetic axis of the permanent magnet (22). The axis of sensitivity of the magnetic field sensor (25) is perpendicular to the field of the permanent magnet (22) and in a plane perpendicular to the surface of the magnetic material (24). A reference sensor (26) for compensating for temperature and stray field effects can be positioned perpendicular to the magnetic axis of the permanent magnet (22) with an axis of sensitivity parallel to the axis of sensitivity of the magnetic field sensor (25).

## Description

### Field of Invention

This invention relates generally to the detection of magnetic materials and, more particularly, to the detection of magnetic materials in which a field is applied to the magnetic materials and the magnetic field arising from the induced magnetization is measured to determine the magnetization of the magnetic material.

### Background of the Invention

Many applications exist in which measurement of the magnetization of a magnetic material is desired. For example, a copier toner reservoir may include, in addition to the toner particles, high coercivity (2,000 Oe) BaFe carrier beads. The nominal toner concentration is one part toner and four parts carrier beads by volume. The ratio of the magnetic carrier beads to the toner particles must be maintained within prescribed limits for proper operation of the copier device. The magnetization of the magnetic material is measured and toner is added as appropriate.

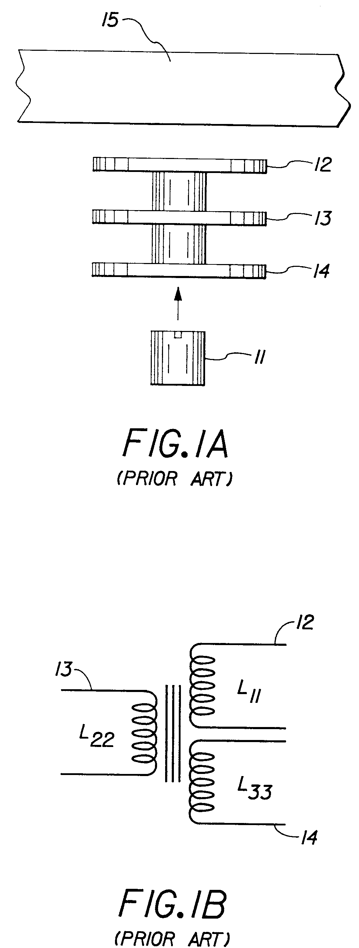

Referring to Fig. 1A and Fig. 1B, a prior art magnetic material measuring device is shown. The device includes a ferrite core 11, a sensor coil 12, an oscillator coil 13, and a reference coil 14. An alternating current (e.g., 260 kHz) is applied to the oscillator coil 13. The ferrite core 11 is nominally centered in the structure. A magnetic field resulting from the current in the oscillator coil 13 is channeled by the ferrite core 11. The sensor coil 12 and the reference coil 14 are wired in opposition. In the absence of any magnetic body to be sensed, the net signal in coils 13 and 14 will be zero. The ferrite core 11 can be moved to cancel any imbalance in the combined signal from sensor coil 12 and reference coil 14. When a ferromagnetic body is positioned near one end of the magnetic field measuring device, a magnetization field will be induced in the ferromagnetic body. This magnetization will couple more strongly to the sensor coil 12 then to the reference coil 14 because of the relative distance between the ferromagnetic body and each of the coils 12 and 14. The magnitude of the resulting signal is used to determine the magnetization or the permeability of material 15. In the application involving the copier toner, the magnetic particle concentration in the toner can be determined by the magnitude of the imbalance signal.

The problem with the measurement of the magnetic particle concentration using the foregoing technique is that the applied field is very small and the coercivity of the ferromagnetic material is very large. Consequently, only a small magnetization is induced in the ferromagnetic material and a correspondingly small field is detected by the magnetic field measuring device. Typically, narrow band, high gain electronics must be used in the detection. In addition, the measuring device is very sensitive to relative positions of the sensor and reference coils due to variations in temperature.

A need has, therefore, been felt for apparatus and a technique for the measurement of the magnetization or permeability of a ferromagnetic material in which a very large magnetic field can magnetize the high coercivity particles or cause their physical rotation. In either event, a large magnetic moment is generated along with a large magnetic field, a magnetic field which can more easily be detected.

### Summary of the Invention

The present invention is directed to overcoming one or more of the problems set forth above. Briefly summarized, according to one aspect of the present invention, a strong permanent magnet generating a large magnetic field is used to induce a magnetic moment in a magnetic material. A sensor is oriented so that its sensitive axis is perpendicular to the field from the magnet. The optimum orientation of the permanent magnet is 45° to the surface of the magnetic material. The magnetic moment is induced in the magnetic material. The induced magnetic moment creates a field which has a large component parallel to the sensitive axis of the sensor. Stray fields and residual temperature effects can be canceled by using a second sensor positioned on the opposite side of the magnet and oriented so that the sensitive axis of the second sensor is oriented parallel to the sensitive axis of the first sensor, and again perpendicular to the field from the permanent magnet.

The signal can be easily detected with an improved signal-to-noise ratio and the signal is virtually independent of temperature using the present invention. In addition, the second sensor can cancel stray fields and can increase the detected signal, thus improving the signal to noise ratio.

These and other aspects, objects, features and advantages of the present invention will be more clearly understood and appreciated from a review of the following detailed description of the preferred embodiments and appended claims, and with reference to the accompanying drawings.

### Brief Description of the Drawings

Figures 1A and 1B are diagrammatic representations of a detector for detecting a field from an induced magnetic moment according to the related art.

Figure 2 is a diagrammatic representation of a detector for detecting a field from an induced magnetic moment according to the present invention.

### Detailed Description of the Invention

Figures 1A and 1B have been described with reference to the related art.

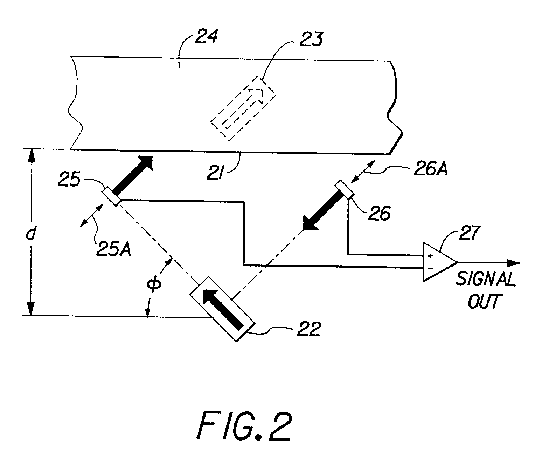

Referring next to Fig. 2, a permanent magnet 22 is placed at a distance d from the surface 21 of a magnetic material. The magnetic axis of the magnet is rotated by an angle φ from an orientation parallel to the surface of the magnetic material 24. In the context of the present invention, the magnetic axis is defined as the vector parallel to the magnetic moment of the permanent magnet which passes through the center of mass of the permanent magnet. An induced magnetic field sensor 25 is positioned along the magnetic axis of the permanent magnet 22 and in close proximity to the surface 21 of the magnetic material. The axis of sensitivity 25A of the induced magnetic field sensor 25 is perpendicular to the field from the permanent magnet 22. In applications requiring higher signal and reduced noise from stray fields and freedom from thermal drift, a second magnetic field sensor 26 is located on the opposite side of the permanent magnet 22 and in close proximity to the surface 21 of the magnetic material. The orientation of the axis of sensitivity 26A of second magnetic field sensor 26 is parallel to the axis of sensitivity 25A of induced magnetic field sensor 25. The output signal from the induced magnetic field sensor 25 and the output signal from second magnetic field sensor 26 are applied to difference amplifier 27. The output signal from difference amplifier 27 is a measure of the permeability of magnetic material 24 wherein temperature and stray field effects have been reduced.

The operation of the present invention functions in the following manner. The field from the permanent magnet 22 induces a magnetic moment in the magnetic material 24 which is equivalent to a magnetic image 23 of the permanent magnet 22. (The concept of a magnetic image for determining magnetic fields is described in "Electromagnetic Fields and Waves" by Paul Lorraine and Dale Corson, W. H. Freeman & Co., San Francisco, 1970.) The field at the induced magnetic field sensor 25 and the second magnetic field sensor 26, positioned outside the magnetic material 24, are oriented such that, in the absence of the magnetic material 24, no magnetic field is detected. In the presence of the magnetic material 24, the induced field, arising from the image magnet 23 internal to the magnetic,material 24, provides a component which can be detected by the magnetic field sensor 25 and, when present, the second magnetic field sensor 26. Any signal that the induced magnetic field sensor 25 detects will be caused by the magnetic moment induced in the magnetic material 24 by the permanent magnet 22. The signal induced in the second magnetic field sensor 26 can be subtracted from the signal induced in the magnetic field sensor 25 to cancel the effects of stray fields and temperature changes. Because the field at the second sensor 26 originating from the image magnet 23 is in a direction opposite to the field at the first sensor 25, this subtraction results in a larger net signal as well as a cancellation of stray fields and temperature drift.

In the preferred embodiment in which the apparatus is used to measure a permeability of a toner sample, the induced magnetic field sensors 25 and 26 are Hall effect devices. The permanent magnet 22 is selected to provide a nominal 1000 Oe field in the sample. This field is sufficiently large to appreciably magnetize the high coercivity BaFe carrier beads which are mixed with the toner particles. The angle φ is selected to be 45°, an angle which provides the maximum signal for sensor 25 as a result of the induced magnetic field. However, the axis can be in the range of 35° to 55°.

It will be now appreciated that there has been presented apparatus and a related method to measure a magnetic field with particular application to the measurement of toner particle concentration in copy machine devices. However, the apparatus can also be used to measure the field arising from the magnetic moment induced in a single layer of recording tape, to measure the induced field from various thicknesses of magnetic materials, to measure the induced field (and therefore the concentration of impurities) from a sample of brass contaminated with iron, to measure the induced field from the portrait region of currency, and to measure the velocity of a moving conductor by measuring the field arising from eddy currents induced by the permanent magnet. At a constant velocity and sample thickness, the induced eddy current field is a measure of the conductivity of the body being tested. The polarity of this field reflects the direction of motion of the conductive body.

Operation of the present invention is believed to be apparent from the foregoing description and drawings, but a few words will be added for emphasis. The invention uses the fact that the magnetic moment induced in a magnetic material by an external magnet can be determined by producing an image magnet symmetrically placed in the magnetic material. As will be clear from Fig. 2, the magnetic field sensor is oriented such that no magnetic field will be detected from the primary permanent magnet. However, the induced image magnet will produce fields which can be readily detected by the magnetic field sensor. It will be clear that second sensor 26 can be used as the magnetic field sensor in the absence of sensor 25. It will be further clear that the requirement on the magnetic field sensor is that the sensor axis be oriented perpendicular to field produced by the permanent magnet alone, and still be close enough to the surface of the magnetic material to be able to detect the magnetic field from the magnetic material under test.

While the invention has been described with particular reference to a preferred embodiment, it will be understood by those skilled in the art that various changes may be made and equivalents may be substituted for elements of the preferred embodiment without departing from the invention. In addition, many modifications may be made to adapt a particular situation and material to a teaching of the invention without departing from the essential teachings of the present invention.

As is evident from the foregoing description, certain aspects of the invention are not limited to the particular details of the examples illustrated and it is, therefore, contemplated that other modifications and applications will occur to those skilled in the art. It is accordingly intended that the claims shall cover all such modifications and applications as do not depart from the true spirit and scope of the invention.

## Claims

1. Apparatus for measuring the permeability of a magnetic material, said apparatus comprising:
a permanent magnet being located proximate a surface of said magnetic material, said permanent magnet having its magnetic moment oriented to have an angle φ with respect to a plane parallel to the said surface of said magnetic material; and
a magnetic field sensor positioned proximate said surface of said magnetic material, said magnetic field sensor having an axis of sensitivity perpendicular to the field of said permanent magnet.

2. The apparatus of claim 1 wherein said magnetic field sensor is positioned on a magnetic axis of said permanent magnet.

3. The apparatus of claim 2 further comprising:
a second magnetic field sensor, said second magnetic field sensor being positioned proximate said surface of said magnetic material, said second magnetic field sensor having an axis of sensitivity perpendicular to said field of said permanent magnet, said second magnetic field sensor having an axis of sensitivity parallel to said axis of sensitivity of said first magnetic field sensor.

4. The method of measuring the magnetic permeability of a magnetic material, the method comprising the steps of:
positioning a permanent magnet in the vicinity of said magnetic material, a magnetic axis of said permanent magnet being parallel to the magnetic moment of said permanent magnet and having an angle φ with respect a surface of said magnetic material; and
positioning a magnetic field sensor along said axis of said permanent magnet proximate said surface of said magnetic material, said magnetic field sensor having an axis of sensitivity perpendicular to said axis of said permanent magnet.

5. The method of claim 4 further including a step of positioning a second magnetic field sensor perpendicular to said axis of said permanent magnet, an axis of sensitivity of said second magnetic field sensor being parallel to said axis of sensitivity of said magnetic field sensor.

6. Apparatus for measuring a magnetization field induced in a magnetic material, said apparatus comprising:
a permanent magnet positioned in a vicinity of a surface of said magnetic material, said permanent magnet having its magnetic axis oriented with an angle φ with respect to said surface of said magnetic material; and
a magnetic field sensor positioned proximate said surface of said magnetic material, said magnetic field sensor having its axis of sensitivity oriented to be perpendicular to the magnetic field from said permanent magnet, said magnetic field sensor positioned on said magnetic axis of said magnetic moment.

7. The apparatus of claim 6 further comprising a second magnetic field sensor, said second magnetic field sensor being positioned proximate said surface of said magnetic material, an axis of said second magnetic field sensor being oriented perpendicular to said magnetic field from said permanent magnet.

8. Apparatus for measuring a velocity of a moving conducting material, said apparatus comprising:
a permanent magnet having a magnetic moment oriented at an angle of φ with respect to said moving conducting material; and
a magnetic field sensor positioned proximate said conducting magnetic material and having an axis of sensitivity perpendicular to said field of said permanent magnet, said magnetic field sensor detecting a magnetic field generated by eddy currents induced in said conducting material by said field from said permanent magnet.

9. The apparatus of claim 8 wherein said magnetic field sensor is positioned on the magnetic axis of said permanent magnetic, said apparatus further comprising a second magnetic field sensor, said second magnetic field sensor positioned proximate said conducting material and having an axis of sensitivity oriented perpendicular to said field of said permanent magnet.

10. The apparatus of claim 9 wherein said second magnetic sensor is positioned perpendicular to said magnetic axis, said axis of sensitivity of said second magnetic sensor being parallel to said axis of sensitivity of said first magnetic field sensor.
